# EUROPEAN PATENT APPLICATION

(11) **EP 2 644 964 A1**
(43) Date of publication of application: **02.10.2013**
(21) Application number: 13158703.2
(22) Date of filing: 12.03.2013
(51) Int. Cl.: F21K 99/00, F21Y 105/00, F21Y 113/00, F21Y 101/02

(54) **Light emitting module and lighting system**

(30) Priority: 26.03.2012 JP 2012069709
(71) Applicant: Toshiba Lighting & Technology Corporation, Yokosuka-shi Kanagawa 237-8510 (JP)
(72) Inventor: Kashiwagi, Takahito, Kanagawa, 237-8510 (JP); Takahashi, Yoshiko, Kanagawa, 237-8510 (JP); Oyaizu, Tsuyoshi, Kanagawa, 237-8510 (JP); Kawashima, Seiko, Kanagawa, 237-8510 (JP); Nishimura, Kiyoshi, Kanagawa, 237-8510 (JP)
(74) Representative: Bokinge, Ole

(57) **Abstract**

A first LED group including a plurality of LEDs (2a) is regularly arranged in a toric shape on the circumference of a center of an approximately rectangular substrate (1) which is formed of ceramics. In addition, the first LED group including the plurality of LEDs (2a) is entirely covered in a toric shape with a sealing member (3a). In addition, a second LED group including a plurality of LEDs (4a) is regularly arranged in a grid shape in the vicinity of the center of the approximately rectangular substrate (1). In addition, the LED group including the plurality of LEDs (4a) is entirely covered with a sealing member (5a). In addition, the sealing member (5a) entirely covers the inside of the toric portion of a first region.

## Description

### FIELD

Embodiments described herein relate generally to a light emitting module, and a lighting system.

### BACKGROUND

In recent years, as a lighting system, a lighting system which includes a power saving light emitting element such as an LED (Light Emitting Diode) is used. The lighting system includes a light emitting element which is able to obtain higher brightness, or illuminance with a smaller power consumption than, for example, an incandescent light bulb in the related art.

Here, there is a case in which the lighting system including a light emitting element includes a plurality of types of light emitting elements of which luminous colors are different on the same substrate. The lighting system emits desired luminous color corresponding to a use by mixing respective luminous colors of the plurality of types of light emitting elements.

However, in the above described related art, when respective heat characteristics of the plurality of types of light emitting elements which are mounted on the same substrate are different, there is a case in which a change in a quantity of light emission of the light emitting elements becomes different along with a temperature rise due to the light emission. There was a concern that, in a light emitting element of which a degree of the change in the quantity of light emission is large under the influence of heat, in particular, a change in the quantity of light emission may occur due to reasons other than the heat influence which is caused along with own light emission, when the light emitting element absorbs heat which is emitted due to light emission caused by another light emitting element. The heat characteristics are also referred to as temperature characteristics, and denote a relationship between heat, or a temperature of a light emitting element and a luminous efficiency. In the light emitting element, when a temperature of the light emitting element rises due to heat emission, or heat absorption, the luminous efficiency decreases. For this reason, in the lighting system, there is a case in which it is not possible to maintain a desired color temperature, or quantity of light emission of luminous color in a preferable range, since the quantity of light emission of the plurality of types of the light emitting elements is changed, respectively, along with the temperature rises in the light emitting elements.

An object of the exemplary embodiments is to provide a light emission module and a lighting system which maintain a desired color temperature, or quantity of light emission of a luminous color in a preferable range in consideration of the above described problems in the related art.

### DESCRIPTION OF THE DRAWINGS

FIG. 1 is a vertical cross-sectional view which illustrates a lighting system on which a light emitting module according to a first embodiment is mounted.
FIG. 2 is a top view which illustrates the light emitting module according to the first embodiment.
FIG. 3 is a horizontal cross-sectional view which illustrates the lighting system on which the light emitting module according to the first embodiment is mounted.
FIG. 4 is a diagram which illustrates electric wiring of the light emitting module according to the first embodiment.
FIG. 5 is a diagram which illustrates reflections of luminous colors of respective light emitting elements in the light emitting module according to the first embodiment.
FIG. 6 is a top view which illustrates a light emitting module according to a second embodiment.
FIG. 7 is a top view which illustrates a light emitting module according to a third embodiment.

### DETAILED DESCRIPTION

Hereinafter, a light emitting module and a lighting system according to embodiments will be described with reference to drawings. Constituent elements having the same function in the embodiments will be given the same reference numerals, and repeated descriptions will be omitted. In addition, the light emitting module and the lighting system which are described in the following embodiments are merely examples, and do not limit the exemplary embodiments. In addition, embodiments in below may be appropriately combined as far as not contradictive.

Light emitting modules 10a to 10c according to a first embodiment include a first light emitting element group which includes a plurality of first light emitting elements (for example, blue LEDs 2a to 2c) which emit a first luminous color, for example, blue light when a current is supplied. The first light emitting elements (for example, blue LEDs 2a to 2c) have first heat characteristics in which a quantity of light emission of the light emitting element is decreased along with a temperature rise of the light emitting element. The light emitting modules 10a to 10c include a second light emitting element group which includes a plurality of second light emitting elements (for example, red LEDs 4a to 4c) which emit second luminous color, for example, red light when a current is supplied. The second light emitting elements (for example, red LEDs 4a to 4c) have second heat characteristics in which a quantity of light emission of the light emitting element is further decreased along with a temperature rise in the light emitting element than the first heat characteristics. The light emitting modules 10a to 10c include a substrate 1 which is formed using a ceramic base material of which thermal conductivity is smaller than 225 [W/m·K] (300 [K] in atmosphere). In the substrate 1, the first light emitting element group is surface mounted in a first region, and the second light emitting element group is surface mounted on a second region which is on the same plane as the first region, and is separated from the first region.

In addition, in the following light emitting modules 10a to 10c according to a second embodiment, a distance (for example, D1) between a first light emitting element group and a second light emitting element group on a substrate 1 is longer than a length (for example, D2) in the vertical direction with respect to the surface of the substrate 1.

In addition, in the following light emitting modules 10a to 10c according to a third embodiment, second light emitting elements (for example, red LEDs 4a to 4c) have a small supplied current than that of first light emitting elements (for example, blue LEDs 2a to 2c).

In addition, in the following light emitting modules 10a to 10c according to a fourth embodiment, the number of second light emitting elements which are included in a second light emitting element group (for example, red LEDs 4a to 4c) is smaller than the number of first light emitting elements which are included in a first light emitting element group (for example, blue LEDs 2a to 2c).

In addition, in the following light emitting modules 10a to 10c according to a fifth embodiment, the substrate 1 is formed by a ceramic base member of any one of alumina, silicon nitride, and silicon oxide.

In addition, in the following light emitting modules 10a to 10c according to a sixth embodiment, the first light emitting elements (for example, blue LEDs 2a to 2c) are arranged in a toric shape on the substrate 1, and the second light emitting elements (for example, red LEDs 4a to 4c) are arranged in a vicinity of a center of the toric shape on the substrate 1.

In addition, in the following light emitting modules 10a to 10c according to a seventh embodiment, two first light emitting element groups including the first light emitting elements (for example, blue LEDs 2a to 2c), and two second light emitting element groups including the second light emitting elements (for example, red LEDs 4a to 4c) are diagonally arranged at a position where is symmetric about a point with respect to a center of the substrate 1 on the substrate 1, respectively.

In addition, in the following light emitting modules 10a to 10c according to a eighth embodiment, one first light emitting element group including the first light emitting elements (for example, blue LEDs 2a to 2c), and one second light emitting element group including the second light emitting elements (for example, red LEDs 4a to 4c) are arranged at a position where is line symmetry with respect to a center line of the substrate 1 on the substrate 1.

In addition, in the following light emitting modules 10a to 10c according to a ninth embodiment, further including, a detection sensor which detects heat or brightness due to light emission of the first light emitting elements (for example, blue LEDs 2a to 2c) and the second light emitting elements (for example red LEDs 4a to 4c) which are provided on the substrate 1, a first control circuit which controls power which is supplied to the first light emitting elements (for example, blue LEDs 2a to 2c) according to a detection result of the heat, or brightness using the detection sensor, and a second control circuit which controls power which is supplied to the second light emitting elements (for example red LEDs 4a to 4c) according to a detection result of the heat, or brightness using the detection sensor.

In addition, in the following light emitting modules 10a to 10c according to a tenth embodiment, the first control circuit controls a driving current, or a driving pulse which is supplied to the first light emitting elements (for example blue LEDs 2a to 2c), and the second control circuit controls a driving current, or a driving pulse which is supplied to the second light emitting elements (for red LEDs 4a to 4c).

A lighting system 100a to 100c according to an eleventh embodiment includes a light emitting module which includes, a first light emitting element group which includes a plurality of first light emitting elements (for example blue LEDs, 2a to 2c) which emit a first luminous color when a current is supplied, and have first heat characteristics in which a quantity of light emission of a light emitting element is decreased along with a temperature rise of the light emitting element, a second light emitting element group which includes a plurality of second light emitting elements (for example, red LEDs 4a to 4c) which emit a second luminous color when a current is supplied, and have second heat characteristics in which a quantity of light emission of a light emitting element is further decreased along with a temperature rise in the light emitting element than the first heat characteristics, and a substrate 1 which is formed using a ceramic base material of which thermal conductivity is smaller than 225 [W/m·K] (300 [K] in atmosphere), and in which the first light emitting element group is surface mounted in a first region, and the second light emitting element group is surface mounted on a second region which is on the same plane as the first region, and is separated from the first region.

In addition, in the following lighting system 100a to 100c according to a twelfth embodiment, in the light emitting module, a distance (for example, D1) between the first light emitting element group and the second light emitting element group is longer than a length (for example, D2) in a vertical direction with respect to a surface of the substrate on the substrate 1.

In addition, in the following lighting system 100a to 100c according to a thirteenth embodiment, the second light emitting elements (for example, red LEDs 4a to 4c) have a smaller supplied current than that of the first light emitting elements (for example, blue LEDs 2a to 2c).

In addition, in the following lighting system 100a to 100c according to a fourteenth embodiment, the number of second light emitting elements (for example, red LEDs 4a to 4c) which are included in the second light emitting element group is smaller than the number of first light emitting elements (for example, blue LEDs 2a to 2c) which are included in the first light emitting element group.

In addition, the following lighting systems 100a to 100c according to a fifteenth embodiment include the light emitting modules 10a to 10c.

In the following embodiments, the light emitting element is described as an LED (Light Emitting Diode), however, it is not limited to this, and may be another light emitting element which emits a predetermined color such as an organic EL (OLEDs (Organic Light Emitting Diodes)), and a semiconductor laser, when a current is supplied.

In addition, in the following embodiments, an LED is configured by a light emitting diode chip which is formed of a gallium-nitrid (GaN) based semiconductor of which luminous color is blue, or a compound-based semiconductor of four chemical materials (Al, In, Ga, P) of which luminous color is red. In addition, a part, or all of the LEDs are mounted by being arranged regularly, at regular intervals in matrix, in zigzag, in a radial pattern, or the like, and for example, using a COB (Chip On Board) technology. Alternatively, the LEDs may be configured as an SMD type (Surface Mount Device). In addition, in the following embodiments, the number of LED configures an LED group using LEDs of the same type in which a design can be changed depending on use of lighting.

In addition, in the following embodiments, a shape of the lighting system has a type of Krypton light bulb, however, it is not limited to this, and may be a general light bulb type, a cannonball type, or the like.

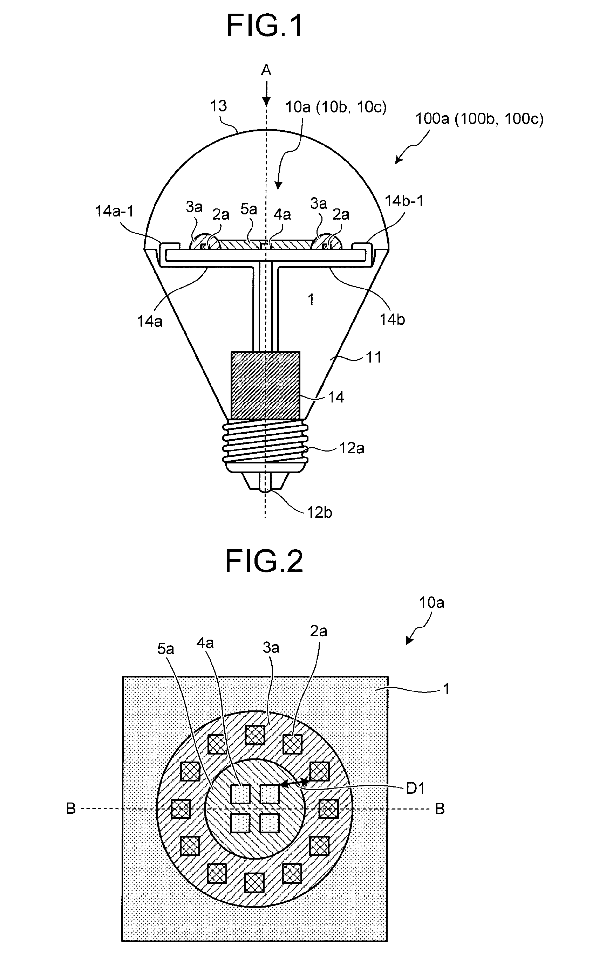

FIG. 1 is a vertical cross-sectional view which illustrates a lighting system on which a light emitting module according to the first embodiment is mounted. As illustrated in FIG. 1, a lighting system 100a includes a light emitting module 10a. In addition, the lighting system 100a according to the first embodiment includes a body 11, a base member 12a, an eyelet unit 12b, a cover 13, a control unit 14, electric wiring 14a, an electrode connection unit 14a-1, electric wiring 14b, and an electrode connection unit 14b-1.

The light emitting module 10a is arranged on the top face of the body 11 in the vertical direction. The light emitting module 10a includes a substrate 1. The substrate 1 is formed of ceramics with low heat conductivity, and for example, is formed of alumina. The heat conductivity of the substrate 1 is, for example, 33 [W/m·K] in an atmosphere of 300 [K].

When the substrate 1 is formed of ceramics, since the substrate has a high mechanical strength, and a high accuracy of dimension, it is possible to increase yields when performing a mass production of the light emitting module 10a, to reduce a manufacturing cost of the light emitting module 10a, and to contribute to a long life of the light emitting module 10a. In addition, since the ceramics has high reflectivity of visible light, it is possible to improve a luminous efficiency of the LED module.

In addition, the substrate 1 may be formed of silicon nitride, silicon oxide, or the like, without being limited to alumina. In addition, the heat conductivity of the substrate 1 is preferably 20 to 70 [W/m·K]. When the heat conductivity of the substrate 1 is 20 to 70 [W/m·K], it is possible to suppress a manufacturing cost, reflectivity, and a heat influence between light emitting elements which are mounted on the substrate 1. In addition, the substrate 1 which is formed using the ceramics with preferable heat conductivity is possible to suppress the heat influence between the light emitting elements which are mounted on the substrate 1, compared to a material with high heat conductivity. For this reason, in the substrate 1 which is formed using the ceramics with preferable heat conductivity, it is possible to make a distance between the light emitting elements which are mounted on the substrate 1 short, and to realize downsizing.

In addition, the substrate 1 may be formed using nitride of aluminum such as aluminum nitride. In this case, the heat conductivity of the substrate 1 is, for example, smaller than 225 [W/m·K] which is the heat conductivity of aluminum of approximately 99.5 mass% in an atmosphere of 300 [K].

In the light emitting module 10a, blue LED 2a is arranged on a circumference on the top face of the substrate 1 in the vertical direction. In addition, in the light emitting module 10a, red LED 4a is arranged in the vicinity of a center on the top face of the substrate 1 in the vertical direction. In the red LED 4a, a quantity of light emission of the light emitting element is further decreased along with a temperature rise in the light emitting element, compared to the blue LED 2a. That is, the heat characteristics of the red LED 4a deteriorate since the quantity of light emission of the light emitting element is further decreased along with the temperature rise in the light emitting element, compared to the blue LED 2a. According to the first embodiment, since the substrate 1 is ceramics with low heat conductivity, it is possible to prevent heat which is emitted from the blue LED 2a from being conducted to the red LEDs 4a through the substrate 1, and to suppress deterioration in a luminous efficiency of the red LED 4a.

In addition, in FIG. 1, the blue LED 2a and the red LED 4a are described by omitting the number thereof. That is, as a first LED group, a plurality of blue LEDs 2a are arranged on the circumference of the top face of the substrate 1 in the vertical direction. In addition, as a second LED group, a plurality of red LEDs 4a are arranged in the vicinity of the center of the top face of the substrate 1 in the vertical direction.

The first LED group including the plurality of blue LEDs 2a is covered with a sealing member 3a from above. The sealing member 3a has a cross section of approximately a semicircle shape, or a trapezoidal shape on the top face of the substrate 1 in the vertical direction, and is formed as a toric shape so as to cover the plurality of blue LEDs 2a. In addition, the second LED group which includes the plurality of red LEDs 4a is covered with a sealing member 5a from above together with an entire concave portion formed by the inner surface of the toric portion which is formed by the sealing member 3a and the substrate 1.

The sealing members 3a and 5a can be formed using various resins such as epoxy resin, urea resin, and silicon resin as a member. The sealing member 5a may be transparent resin with high diffusibility, without including phosphor. The sealing members 3a and 5a are formed using resin of different types. In addition, a refractive index of light of the sealing member 3a n1, a refractive index of light of the sealing member 5a n2, and a refractive index of light of gas sealed in a space which is formed by the body 11 and the cover 13 n3 have a magnitude relationship of n3<n1<n2. Hereinafter, the gas which is sealed in the space which is formed by the body 11 and the cover 13 is referred to as "sealed gas". The sealed gas is, for example, atmosphere.

In addition, in the light emitting module 10a, an electrode 6a-1 which will be described later is connected to the electrode connection unit 14a-1. In addition, in the light emitting module 10a an electrode 8a-1 which will be described later is connected to the electrode connection unit 14b-1.

The body 11 is formed using metal with good heat conductivity, for example, aluminum. The body 11 forms a columnar shape of which a horizontal cross section is approximately a circle, one end thereof is attached with the cover 13, and the other end is attached with the base member 12a. In addition, the body 11 is formed so that the outer peripheral surface forms an approximately conical tapered surface of which a diameter becomes sequentially small from the one end toward the other end. An appearance of the body 11 is formed in a shape which is similar to a silhouette of a neck portion in a mini krypton light bulb. In the body 11, a plurality of radiating fins which are radially protruded from the one end toward the other end (not shown) are integrally formed in the outer peripheral surface.

The base member 12a is, for example, an E-type base of an Edison type, and includes a cylindrical shell of a copper sheet including thread, and the conductive eyelet unit 12b which is provided at an apex portion of the lower end of the shell through an electric insulation unit. An opening portion of the shell is fixed to an opening portion of the other end of the body 11 being electrically insulated. The shell and the eyelet unit 12b are connected with an input line (not shown) which is derived from a power input terminal of a circuit board (not shown) in the control unit 14.

The cover 13 configures a globe, and for example, is formed in a smooth curved shape which is similar to the mini krypton light bulb including an opening portion at one end, using milky-white polycarbonate. An opening end portion of the cover 13 is fixed by being fitted into the body 11 so as to cover the light emitting surface of the light emitting module 10a. In this manner, the lighting system 100a is configured as a lamp with a base which can substitute for the mini krypton light bulb, in which a globe as the cover 13 is included at one end, the E-type base member 12a is provided at the other end, and the entire appearance is similar to a silhouette of the mini krypton light bulb. In addition, as a method of fixing the cover 13 to the body 11, any of adhering, fitting, screwing, locking, and the like may be used.

The control unit 14 accommodates a control circuit (not shown) which controls lighting of the blue LEDs 2a and the red LEDs 4a which are mounted on the substrate 1 so as to be electrically insulated from the outside. The control unit 14 supplies a DC voltage to the blue LEDs 2a and the red LEDs 4a by converting an AC voltage to the DC voltage by a control using the control circuit. In addition, in the control unit 14, an output terminal of the control circuit is connected with the electric wiring 14a for supplying power to the blue LEDs 2a and the red LEDs 4a. In addition, in the control unit 14, an input terminal of the control circuit is connected with the second electric wiring 14b. The electric wiring 14a and the electric wiring 14b are covered to be insulated.

The electric wiring 14a is derived to an opening portion at the one end of the body 11 through a through hole (not shown) which is formed in the body 11, and a guide groove (not shown). In the electric wiring 14a, the electrode connection unit 14a-1 as a tip end portion of which an insulation cover is peeled is connected to the electrode 6a-1 of wiring which is arranged on the substrate 1. The electrode 6a-1 will be described later.

In addition, the electric wiring 14b is derived to an opening portion at the one end of the body 11 through a through hole (not shown) which is formed in the body 11, and a guide groove (not shown). In the electric wiring 14b, the electrode connection unit 14b-1 as a tip end portion of which an insulation cover is peeled is connected to the electrode 8a-1 of wiring which is arranged on the substrate 1. The electrode 8a-1 will be described later.

In this manner, the control unit 14 supplies power which is input through the shell and the eyelet unit 12b to the blue LEDs 2a and the red LEDs 4a through the electric wiring 14a. In addition, the control unit 14 collects the power which is supplied to the blue LEDs 2a and the red LEDs 4a through the electric wiring 14b.

FIG. 2 is a top view which illustrates the light emitting module according to the first embodiment. FIG. 2 is the top view of the light emitting module 10a which is viewed in an arrow 'A' direction in FIG. 1. As illustrated in FIG. 2, the first LED group including the plurality of blue LEDs 2a is regularly arranged in a toric shape on the circumference at the center of the approximately rectangular substrate 1. In addition, the first LED group including the plurality of blue LEDs 2a is entirely covered with the sealing member 3a in a toric shape. In the substrate 1, a region which is covered with the sealing member 3a is referred to as a first area.

In addition, as illustrated in FIG. 2, the second LED group including the plurality of red LEDs 4a is regularly arranged in a lattice shape in the vicinity of the center of the approximately rectangular substrate 1. In addition, the second LED group including the plurality of red LEDs 4a is entirely covered with the sealing member 5a. In addition, the sealing member 5a entirely covers the inside of the above described toric portion in the first region. In the substrate 1, a region which is covered with the sealing member 5a is referred to as a second region.

As illustrated in FIG. 2, a shortest distance between the blue LED 2a and the red LED 4a is set to a distance D1 between the blue LED 2a and the red LED 4a. In addition, the distance between the blue LED 2a and the red LED 4a is not limited to the shortest distance between the blue LED 2a and the red LED 4a, and may be a distance between a center position of the first LED group and a center position of the second LED group. In the example which is illustrated in FIG. 2, for example, the center position of the first LED group is a circumference which passes through each center of the blue LEDs 2a which are arranged in the toric shape. In addition, for example, the center position of the second LED group is a center of the red LEDs 4a which are arranged in the lattice shape. In this case, the distance between the blue LED 2a and the red LED 4a is a distance between the center at which the red LEDs 4a are arranged in the lattice shape and one point on the circumference which passes through each center of the blue LEDs 2a which are arranged in the toric shape.

The light emitting module 10a suppresses, for example, an influence which is caused when heat emitted from the blue LEDs is received by the red LEDs, even when a plurality of types of LEDs of which the heat characteristics are greatly different are arranged in combination on the ceramics substrate 1 by being separated into regions by the type of LEDs. Accordingly, the light emitting module 10a easily obtains desired luminous characteristics.

In addition, in the light emitting module 10a, for example, the blue LEDs and the red LEDs are arranged by being separated into regions. For this reason, in the light emitting module 10a, for example, since the heat which is emitted from the blue LEDs is suppressed so as not to be conducted to the red LEDs, it is possible to improve the heat characteristic of the whole of light emitting module 10a.

In addition, the number of the blue LEDs 2a and the red LEDs 4a, and positions which are illustrated in FIG. 2 are merely examples. That is, when it is a configuration in which the red LEDs 4a are regularly arranged in the vicinity of the center of the substrate 1, and the blue LEDs 2a are regularly arranged so as to surround the red LEDs 4a, it may be any methods. Alternatively, for example, when the number of red LEDs 4a of which the heat characteristics are inferior to that of the blue LEDs 2a is small, it is possible to reduce a deterioration in the entire luminous characteristic of the light emitting module 10a due to the deterioration in the luminous characteristics of the red LEDs 4a which are caused by the heat.

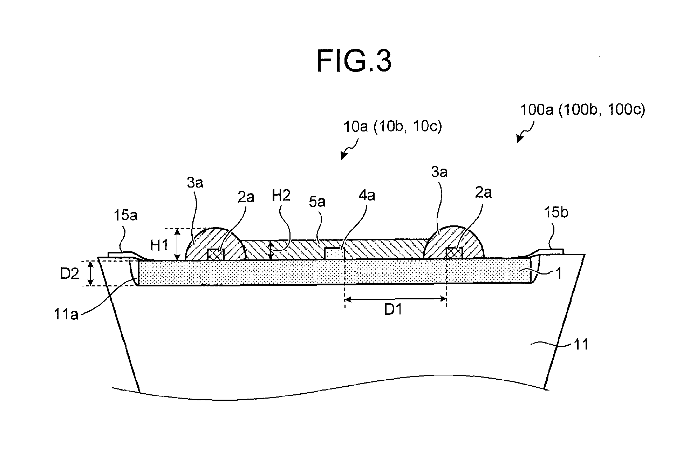

FIG. 3 is a horizontal cross-sectional view which illustrates the lighting system on which the light emitting module according to the first embodiment is mounted. FIG. 3 is a cross-sectional view in which the light emitting module 10a in FIG. 2 is taken along line B-B. In FIG. 3, descriptions of the cover 13, or the lower portion of the body 11 of the lighting system 100a are omitted. As illustrated in FIG. 3, the body 11 of the lighting system 100a includes a concave portion 11a which accommodates the substrate 1 of the light emitting module 10a, fixing members 15a and 15b which fix the substrate 1. In the light emitting module 10a, the substrate 1 is accommodated in the concave portion 11a of the body 11.

In addition, when an edge portion of the substrate 1 is pressed toward the lower part of the concave portion 11a by a pressing force of the fixing members 15a and 15b, the light emitting module 10a is fixed to the body 11. In this manner, the light emitting module 10a is attached to the lighting system 100a. In addition, a method of attaching the light emitting module 10a to the lighting system 100a is not limited to the method which is illustrated in FIG. 3, and may be any of adhering, fitting, screwing, locking, and the like.

As illustrated in FIG. 3, the distance D1 between the blue LED 2a and red LED 4a is longer than a thickness D2 of the substrate 1 in the vertical direction. Heat that is emitted by light emitting from the blue LEDs 2a and red LEDs 4a is easily conducted in the horizontal direction rather than the vertical direction on the substrate 1. For this reason, for example, heat which is emitted from the blue LEDs 2a is conducted to the red LEDs 4a through the horizontal direction of the substrate 1, and the luminance efficiency of the red LEDs 4a further deteriorates. However, when setting the distance D1 between the blue LED 2a and red LED 4a to be longer than the thickness D2 of the substrate 1 in the vertical direction, it is possible to prevent the heat which is emitted from the blue LEDs 2a from being conducted to the red LEDs 4a through the horizontal direction of the substrate 1. Accordingly, it is possible to suppress the deterioration in the luminous efficiency of the red LEDs 4a.

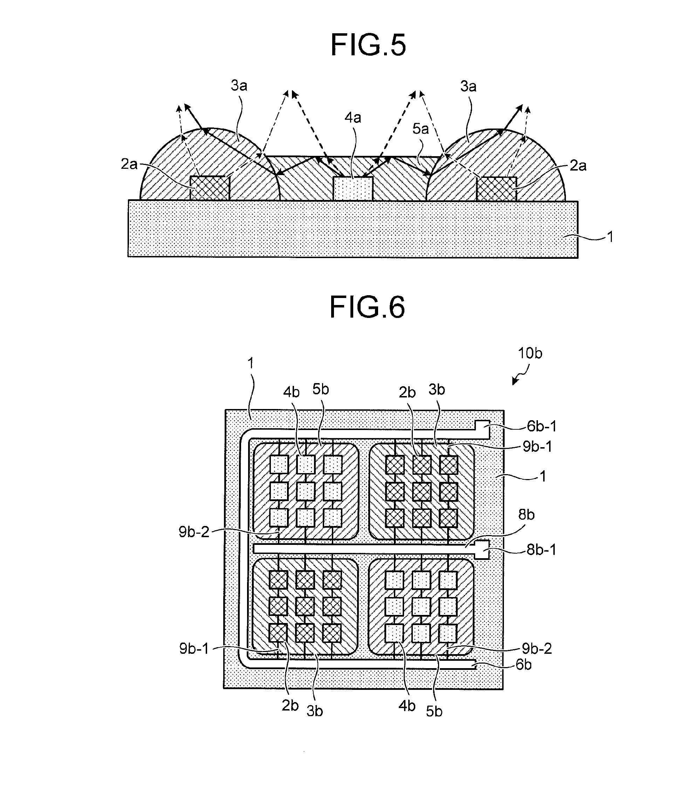

In addition, as illustrated in FIG. 3, a height H1 of the sealing member 3a is higher than a height H2 of the sealing member 5a. An effect thereof will be described later with reference to FIG. 5. In addition, the height H1 of the sealing member 3a and the height H2 of the sealing member 5a may be the same.

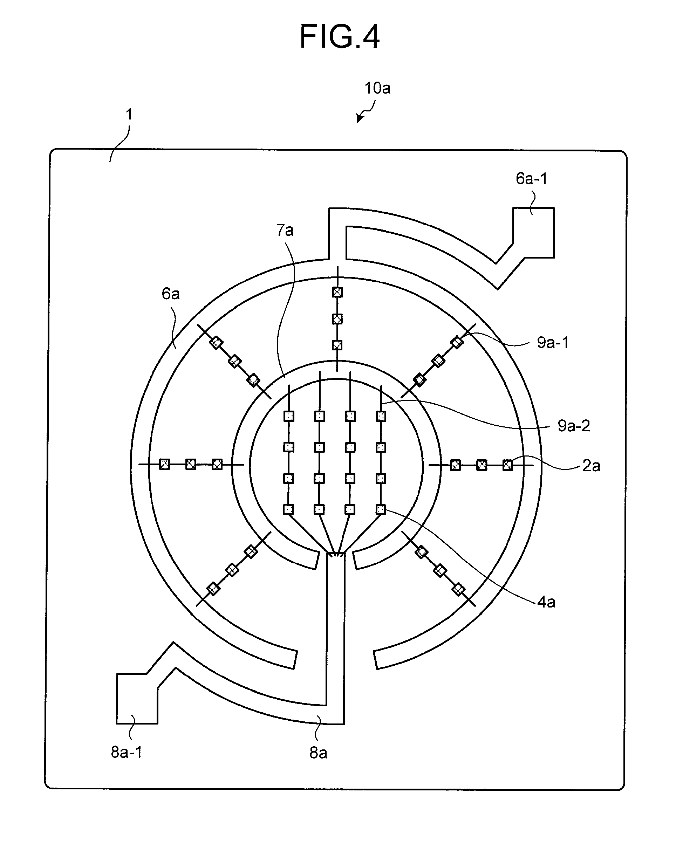

FIG. 4 is a diagram which illustrates electric wiring of the light emitting module according to the first embodiment. As illustrated in FIG. 4, the light emitting module 10a includes the electrode 6a-1 which is connected to the electrode connection unit 14a-1 of the lighting system 100a, and wiring 6a which is extended from the electrode 6a-1 on the substrate 1. In addition, the light emitting module 10a includes wiring 7a which is connected to the wiring 6a in parallel through the plurality of blue LEDs 2a which are connected in series by a bonding wire 9a-1 on the substrate 1. In addition, the light emitting module 10a includes wiring 8a which is connected to the wiring 7a in parallel through the plurality of red LEDs 4a which are connected in series by a bonding wire 9a-2 on the substrate 1. The wiring 8a includes the electrode 8a-1 which is connected to the electrode connection unit 14b-1 of the lighting system 100a at a tip end which is extended.

In this manner, by connecting the plurality of blue LEDs 2a and the plurality of red LEDs 4a which are connected in series in parallel by the bonding wire 9a-1, and the bonding wire 9a-2, an amount of electric current which flows in the vicinity of each blue LED 2a and red LED 4a is suppressed, and emitting of heat is suppressed. Accordingly, deterioration in the luminous characteristic due to the heat emission is reduced in the light emitting module 10a. Further, for example, the number of parallel connections of the red LEDs 4a which are connected in series by the bonding wire 9a-2 is set to be larger than that which is illustrated in FIG. 4, and a current which flows in one red LED 4a is set to be smaller than a current which flows in one blue LED 2a. In this manner, deterioration in the entire luminous characteristic of the light emitting module 10a is reduced which is caused by the deterioration in the luminous characteristics of the red LEDs 4a due to heat.

FIG. 5 is a diagram which illustrates reflection of luminous color of each light emitting element in the light emitting module according to the first embodiment. As an assumption in FIG. 5, as described above, the refractive index of light of the sealing member 3a n1, the refractive index of light of the sealing member 5a n2, and the refractive index of light of the sealed gas which is sealed in the space formed by the body 11 and the cover 13 n3 have a magnitude relationship of n3<n1<n2.

Then, as denoted by a solid arrow in FIG. 5, light which is emitted from the red LED 4a is approximately totally reflected on the interface between the sealing member 5a and the sealed gas, and proceeds in the direction of the sealing member 3a due to the above described magnitude relationship in the refractive indices. In addition, as denoted by the solid arrow in FIG. 5, the light which is reflected on the interface between the sealing member 5a and the sealed gas, and proceeds to the direction of the sealing member 3a refracts on the interface between the sealing member 5a and the sealing member 3a, and proceeds to the inside of the sealing member 3a due to the above described magnitude relationship in the refractive indices.

On the other hand, as is denoted by an arrow of two dotted dashed line in FIG. 5, light which is emitted from the blue LED 2a refracts on the interface between the sealing member 3a and the sealed gas, and proceeds to the direction of the sealed gas due to the above described magnitude relationship in the refractive indices. In addition, most of light which is emitted from the blue LED 2a is reflected on the interface between the sealing members 3a and 5a due to the above described magnitude relationship in the refractive indices. In addition, the height H1 of the sealing member 3a is larger than the height H2 of the sealing member 5a. For this reason, it is possible to set an area of the interface between the sealing member 3a and the sealed gas to be large, while setting an area of the interface between the sealing member 3a and the sealing member 5a to be small.

In this manner, as illustrated in FIG. 5, since most of the light which is emitted from the blue LED 2a, and the light which is emitted from the red LED 4a are output by being moderately composed in the vicinity of the interface between the sealing member 3a and the sealed gas, it is possible to make the light emitted be uniformed. In addition, the light emitting module 10a efficiently extracts the light which is emitted from the red LED 4a, and efficiently composed with the light which is emitted from the blue LED 2a, it is possible to reduce the number of red LEDs 4a to be mounted. Accordingly, in the light emitting module 10a, deterioration in the entire luminous characteristic which is caused by the deterioration in the luminous characteristic of the red LEDs 4a due to heat is suppressed.

In addition, as denoted by an arrow of a broken line in FIG. 5, a part of the light which is emitted from the red LED 4a is refracted and proceeds to the direction of the sealed gas at the upper part of the sealing member 5a without reflecting on the interface between the sealing member 5a and the sealed gas. On the other hand, as denoted by an arrow of one dotted dashed line in FIG. 5, a part of the light which is emitted from the blue LED 2a is refracted on the interface between the sealing member 3a and the sealed gas, and proceeds to the direction of the sealed gas at the upper part of the sealing member 5a. In this manner, since the height of the sealing member 3a is larger than the height of the sealing member 5a, even when a part of the light which is emitted from the red LED 4a is output to the upper part from the sealing member 5a, the light of the blue LED 2a which is output from the upper region on the sealing member 5a side in the sealing member 3a, and the light of the red LED 4a which is output from the sealing member 5a are further uniformly mixed. Accordingly, even when LEDs of which luminous colors are different are provided in separate regions, it is possible to further suppress an uneven color when mixing colors.

In the light emitting module 10a, it is possible to avoid absorption of light by the phosphor, and to increase luminous efficiency by sealing the second region in which an amount of light emission is small, for example, the red LEDs 4a are arranged, using transparent resin not including the phosphor. In addition, in the light emitting module 10a, when the second region in which a predetermined number of red LEDs 4a are arranged is sealed with the transparent resin with high diffusibility, color unevenness of the LEDmodule is suppressed since red light is efficiently diffused. That is, in the light emitting module 10a, it is possible to reduce decreasing in a color rendering property, and in the luminous efficiency of light which is emitted.

In addition, according to the above described first embodiment, the blue LEDs 2a are arranged on the substrate 1 in the toric shape, and the red LEDs 4a are arranged in the vicinity of the center of the toric shape. However, the shape is not limited to the toric shape, and may be any shape, if it is a shape which forms a ring shape such as a rectangular shape, a diamond shape, and other than those, without being limited to the toric shape.

According to the first embodiment, the light emitting module 10a includes the first light emitting element group which is formed by the plurality of first light emitting elements (for example, blue LED 2a) which emit a first light color due to a supply of current, and have first heat characteristics in which the amount of light emission of the light emitting element is decreased along with a temperature rise in the light emitting element. In addition, the light emitting module 10a includes the second light emitting element group which is formed by the plurality of second light emitting elements (for example, red LED 4a) which emit a second luminous color due to a supply of current, and have second heat characteristics in which the quantity of light emission of the light emitting element which is decreased along with the temperature rise in the light emitting element is further decreased than the first heat characteristics. In addition, the light emitting module 10a includes the substrate 1 which is formed of a ceramic base material of which the heat conductivity is smaller than 225 [W/m·K] (300 [K] in atmosphere), and of which the first light emitting element group is surface mounted on the first region, and the second light emitting element group is surface mounted on the second region which is on the same plane as that in the first region, and is separated from the first region. In this manner, in the light emitting module, it is possible to further reduce the decrease in the luminous efficiency of the second light emitting element (for example, red LED 4a) of which the heat characteristics are inferior to those in the first light emitting element (for example, blue LED 2a), by being influenced by heat which is emitted from the first light emitting element (for example, blue LED 2a).

In addition, in the light emitting module 10a, the distance D1 between the first light emitting element group and the second light emitting element group is larger than the length D2 in the vertical direction with respect to the surface of the substrate 1 on the substrate. In this manner, in the light emitting module 10a, it is possible to further reduce the decrease in the luminous efficiency of the second light emitting element (for example, red LED 4a) of which the heat characteristics are inferior to those in the first light emitting element (for example, blue LED 2a) by being influenced by the heat which is emitted from the first light emitting element (for example, blue LED 2a).

In addition, in the light emitting module 10a, the current which is supplied to the second light emitting element (for example, red LED 4a) is smaller than the current which is supplied to the first light emitting element (for example, blue LED 2a). Due to this, it is possible to further reduce the decrease in the luminous efficiency of the second light emitting element (for example, red LED 4a) of which the heat characteristic is inferior to those in the first light emitting element (for example, blue LED 2a) due to the heat emission of the second light emitting element (for example, red LED 4a).

In addition, in the light emitting module 10a, the number of second light emitting elements (for example, red LED 4a) which are included in the second light emitting element group is small than the number of first light emitting elements (for example, blue LED 2a) which are included in the first light emitting element group. Due to this, it is possible to further reduce the decrease in the luminous efficiency of the second light emitting element (for example, red LED 4a) of which the heat characteristic is inferior to those in the first light emitting element (for example, blue LED 2a) due to the heat emission of the second light emitting element (for example, red LED 4a).

An arrangement of LEDs in a second embodiment is different from that in the first embodiment. Since the second embodiment is the same as the first embodiment in other points than that, descriptions thereof will be omitted. FIG. 6 is a top view which illustrates a light emitting module according to the second embodiment. FIG. 6 is a top view of a light emitting module 10b according to the second embodiment which is viewed in the arrow 'A' direction in FIG. 1.

As illustrated in FIG. 6, in the light emitting module 10b, two first LED groups including a plurality of blue LEDs 2b are diagonally arranged on the substrate 1. In addition, in the light emitting module 10b, two second LED groups including a plurality of red LEDs 4b are diagonally arranged so as to be symmetric to the arrangement of the first LED group with respect to the center of the substrate 1 on the substrate 1.

The light emitting module 10b includes an electrode 6b-1 which is connected to the electrode connection unit 14a-1 of a lighting system 100b, and wiring 6b which is extended from the electrode 6b-1 on the substrate 1. In addition, the light emitting module 10b includes the blue LEDs 2b which are connected in series by a bonding wire 9b-1, and wiring 8b which is connected to the wiring 6b in parallel through the red LEDs 4b which are connected in series by a bonding wire 9b-2 on the substrate 1. The wiring 8b includes an electrode 8b-1 which is connected to the electrode connection unit 14b-1 of the lighting system 100b at a tip end which is extended. In addition, the blue LEDs 2b have the same heat characteristics as those in the blue LEDs 2a according to the first embodiment. In addition, the red LEDs 4b have the same heat characteristics as those in the red LEDs 4a according to the first embodiment.

As illustrated in FIG. 6, when the blue LEDs 2b and the red LEDs 4b are arranged on the substrate 1, a first region which is sealed with a sealing member 3b, and a second region which is sealed with a sealing member 5b are located at a position where it is symmetrical about a point with respect to the center of the substrate 1. Accordingly, in the light emitting module 10b, it is possible to easily obtain a desired luminous pattern, and brightness, or hue of light by composing light which is emitted in each of the blue LEDs 2b and the red LEDs 4b in a good balance.

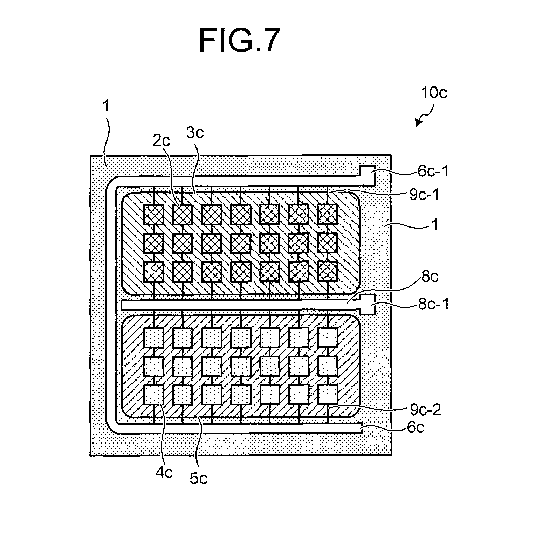

An arrangement of LEDs in a third embodiment is different from those in the first and second embodiments. Since the third embodiment is the same as the first and second embodiments in other points than that, descriptions thereof will be omitted. FIG. 7 is a top view which illustrates a light emitting module according to the third embodiment. FIG. 7 is the top view of a light emitting module 10c according to the third embodiment which is viewed in the arrow 'A' direction in FIG. 1.

As illustrated in FIG. 7, in the light emitting module 10c, a first LED group including a plurality of blue LEDs 2c is arranged in one region of the substrate 1 which is equally divided. In addition, in the light emitting module 10c, a second LED group including a plurality of red LEDs 4c is arranged in the other region, in which the first LED group is not arranged, of the substrate 1 which is equally divided.

The light emitting module 10c includes an electrode 6c-1 which is connected to the electrode connection unit 14a-1 of a lighting system 100c, and wiring 6c which is extended from the electrode 6c-1 on the substrate 1. In addition, the light emitting module 10c includes the plurality of blue LEDs 2c which are connected in series by a bonding wire 9c-1, and wiring 8c which is connected to the wiring 6c in parallel through the plurality of red LEDs 4c which are connected in series by a bonding wire 9c-2 on the substrate 1. The wiring 8c includes an electrode 8c-1 which is connected to the electrode connection unit 14b-1 of the lighting system 100c at a tip end which is extended. In addition, the blue LEDs 2c have the same heat characteristics as those in the blue LEDs 2a according to the first embodiment. In addition, the red LEDs 4c have the same heat characteristics as those in the red LEDs 4a according to the first embodiment.

As illustrated in FIG. 7, a first region which is sealed with a sealing member 3c by arranging the blue LEDs 2c and the red LEDs 4c on the substrate 1, and a second region which is sealed with a sealing member 5c are formed by being separated. Accordingly, the control unit 14 of the lighting system 100c can easily perform a driving control and heat managing of the respective blue LEDs 2c and red LEDs 4c. In addition, in the light emitting module 10c, it is possible to control deterioration of the whole heat characteristic which is caused by deterioration of heat characteristics of the red LEDs 4c due to heat.

The lighting systems 100a to 100c which are described in the above described embodiments have one system of a control circuit which supplies power to the LEDs. However, it is not limited to this, and the lighting systems 100a to 100c may include a sensor which detects heat, or brightness of the LEDs on the substrate 1. In addition, the lighting systems 100a to 100c may include a control circuit of two systems which individually controls a driving current, or the driving pulse width of the blue LEDs 2a to 2c, and the red LEDs 4a to 4c, respectively, according to a detection result of the sensor. In the light emitting modules 10a to 10c, since the blue LEDs 2a to 2c and the red LEDs 4a to 4c are arranged in separate regions, it is possible to control the light emission of each LED efficiently.

In addition, according to the above described embodiments, the blue LEDs 2a to 2c are set to the first light emitting elements, and the red LEDs 4a to 4c are set to the second light emitting elements. However, it is not limited to this, and if it is a combination of the first light emitting elements and the second light emitting elements of which the heat characteristic is inferior to that of the first light emitting elements, it may be any light emitting elements regardless of the luminous color. In addition, in the above described embodiments, the material of the sealing members 3a to 3c, and the material of the sealing members 5a to 5c are set to be different, and refractive index of each light is set to be different. However, it is not limited to this, and the sealing members 3a to 3c, and the sealing members 5a to 5c may be configured by the same material. In addition, the sealing methods of the blue LEDs 2a to 2c and the red LEDs 4a to 4c using the sealing members 3a to 3c, and the sealing members 5a to 5c are not limited to those which are described in the embodiments, and various methods may be used.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting module (10a to 10c) comprising:
a first light emitting element group which includes a plurality of first light emitting elements (2a to 2c) which emit a first luminous color when a current is supplied, and have first heat characteristics in which a quantity of light emission of a light emitting element is decreased along with a temperature rise of the light emitting element;
a second light emitting element group which includes a plurality of second light emitting elements (4a to 4c) which emit a second luminous color when a current is supplied, and have second heat characteristics in which a quantity of light emission of a light emitting element is further decreased along with a temperature rise in the light emitting element than the first heat characteristics; and
a substrate (1) which is formed using a ceramic base material of which thermal conductivity is smaller than 225 [W/m·K] (300 [K] in atmosphere), and in which the first light emitting element group is surface mounted in a first region, and the second light emitting element group is surface mounted on a second region which is on the same plane as the first region, and is separated from the first region.

2. The light emitting module (10a to 10c) according to claim 1,
wherein a distance between the first light emitting element group and the second light emitting element group is longer than a length in a vertical direction with respect to a surface of the substrate (1) on the substrate (1).

3. The light emitting module (10a to 10c) according to claim 1 or 2,
wherein the second light emitting elements (4a to 4c) have a smaller supplied current than that of the first light emitting elements (2a to 2c).

4. The light emitting module (10a to 10c) according claim 1, 2 or 3,
wherein the number of second light emitting elements (4a to 4c) which are included in the second light emitting element group is smaller than the number of first light emitting elements (2a to 2c) which are included in the first light emitting element group.

5. The light emitting module (10a to 10c) according to any one of claims 1 to 4,
wherein the substrate (1) is formed by a ceramic base member of any one of alumina, silicon nitride, and silicon oxide.

6. The light emitting module (10a to 10c) according to any one of claims 1 to 5,
wherein the first light emitting elements (2a to 2c) are arranged in a toric shape on the substrate (1), and
wherein the second light emitting elements (4a to 4c) are arranged in a vicinity of a center of the toric shape on the substrate (1).

7. The light emitting module (10a to 10c) according to any one of claims 1 to 5,
wherein two first light emitting element groups including the first light emitting elements (2a to 2c), and two second light emitting element groups including the second light emitting elements (4a to 4c) are diagonally arranged at a position where is symmetric about a point with respect to a center of the substrate (1) on the substrate (1), respectively.

8. The light emitting module (10a to 10c) according to any one of claims 1 to 5,
wherein one first light emitting element group including the first light emitting elements (2a to 2c), and one second light emitting element group including the second light emitting elements (4a to 4c) are arranged at a position where is line symmetry with respect to a center line of the substrate (1) on the substrate (1).

9. The light emitting module (10a to 10c) according to any one of claims 1 to 8, further comprising:
a detection sensor which detects heat or brightness due to light emission of the first light emitting elements (2a to 2c) and the second light emitting elements (4a to 4c) which are provided on the substrate (1);
a first control circuit which controls power which is supplied to the first light emitting elements (2a to 2c) according to a detection result of the heat, or brightness using the detection sensor; and
a second control circuit which controls power which is supplied to the second light emitting elements (4a to 4c) according to a detection result of the heat, or brightness using the detection sensor.

10. The light emitting module (10a to 10c) according to claim 9,
wherein the first control circuit controls a driving current, or a driving pulse which is supplied to the first light emitting elements (2a to 2c), and
wherein the second control circuit controls a driving current, or a driving pulse which is supplied to the second light emitting elements (4a to 4c).

11. A lighting system (100a to 100c) comprising:
the light emitting module (10a to 10c) according to any one of claims 1 to 10; and
a body (11) in which the light emitting module (10a to 10c) is provided.
